# EUROPEAN PATENT APPLICATION

(11) **EP 2 579 320 A2**
(43) Date of publication of application: **10.04.2013**
(21) Application number: 12162300.3
(22) Date of filing: 29.03.2012
(51) Int. Cl.: H01L 31/0224

(54) **Photovoltaic device**

(30) Priority: 06.10.2011 US 201161544111 P
(71) Applicant: Samsung SDI Co., Ltd., Yongin-si, Gyeonggi-do (KR)
(72) Inventor: Kim, Young-Su, Gyeonggi-do, Seoul 446-920 (KR); Lee, Doo-Youl, Gyeonggi-do (KR); Kim, Young-Jin, Gyeonggi-do (KR); Mo, Chan-Bin, Gyeonggi-do (KR); Park, Young-Sang, Gyeonggi-do (KR)
(74) Representative: Mounteney, Simon James

(57) **Abstract**

A photovoltaic device comprising a semiconductor substrate doped with an impurity having a first polarity, a base layer doped with an impurity having the said first polarity and an emitter layer doped with an impurity having a second polarity. The said base layer and emitter layer being situated over a surface of the substrate, a first electrode, and a second electrode. The base layer comprises a plurality of base portions, the emitter layer comprises a plurality of emitter portions, at least some of the base portions and at least some of the emitter portions are interspersed with each other. The first electrode comprises a first electrode bus bar and a plurality of first electrode branches extending from the first electrode bus bar. The second electrode comprises a second electrode bus bar and a plurality of second electrode branches extending from the second electrode bus bar and interspersed with the first electrode branches. The first electrode is situated over at least part of the emitter layer and the second electrode is situated over at least part of the base layer. The second electrode bus bar is elongate and extends along a diced edge of the substrate.

## Description

### BACKGROUND OF THE INVENTION

### FIELD OF THE INVENTION

One or more embodiments of the present invention relate to photovoltaic devices.

### DESCRIPTION OF RELATED ART

To fabricate a photovoltaic device, a p-n junction is formed by doping an n-type impurity (or a p-type impurity) into a p-type substrate (or an n-type substrate), and thus an emitter is formed. Electron-hole pairs formed via reception of light are separated. Here, electrons are collected by an electrode in an n-type region, whereas holes are collected by an electrode in a p-type region. Therefore, power is generated.

A photovoltaic device may have a structure in which electrodes are respectively arranged on a front surface as a light-receiving surface and on a rear surface. Here, if an electrode is arranged on the front surface, an area for receiving light is reduced by as much as an area of the electrode. To resolve the area reduction problem, a back contact structure in which electrodes are arranged only on a rear surface of a substrate is employed.

### SUMMARY

According to a first aspect of the invention there is provided a photovoltaic device as set out in Claim 1. Further features are set out in Claims 2 to 15.

### BRIEF DESCRIPTION OF THE DRAWINGS

FIG. 1A is a schematic perspective view of a photovoltaic device according to an embodiment of the present invention;

FIG. 1B is a sectional view taken along a line lb-lb of FIG. 1A;

FIG. 2A is a rear view of a photovoltaic device according to an embodiment of the present invention, showing first and second metal electrodes, an emitter layer, and a base layer;

FIG. 2B is a rear view of a photovoltaic device according to another embodiment of the present invention, showing first and second metal electrodes, an emitter layer, and a base layer;

FIG. 3A is a perspective view of a semiconductor substrate during an operation of providing the semiconductor substrate of a process of fabricating a photovoltaic device according to an embodiment of the present invention;

FIG. 3B is a perspective view of a semiconductor substrate according to a modification of the embodiment shown in FIG. 3A;

FIG. 4 is a perspective view of a state during operations of forming a passivation layer and an anti-reflection layer of a process of fabricating a photovoltaic device according to an embodiment of the present invention;

FIG. 5A is a perspective view of a state in which a passivation layer and an anti-reflection layer are formed during a process of fabricating a photovoltaic device according to an embodiment of the present invention;

FIG. 5B is a sectional view taken along a line VB-VB of FIG. 5A;

FIG. 6A is a perspective view of a state in which an insulation layer is formed during a process of fabricating a photovoltaic device according to an embodiment of the present invention;

FIG. 6B is a sectional view taken along a line VIB-VIB of FIG. 6A;

FIG. 7A is a perspective view of a state in which first and second metal electrodes are formed during a process of fabricating a photovoltaic device according to an embodiment of the present invention;

FIG. 7B is a sectional view taken along a line VIIB-VIIB of FIG. 7A;

FIG. 7C is a rear view of FIG. 7A;

FIG. 8A is a perspective view of a state in which a semiconductor substrate is diced along a dicing line C-C of FIG. 7A during a process of fabricating a photovoltaic device according to an embodiment of the present invention;

FIG. 8B is a rear view of FIG. 8A;

FIGS. 9A and 9B show results of measuring quantum efficiencies (QEs) of a back contact photovoltaic device using a laser beam induced current (LBIC) method;

FIG. 10 shows an embodiment of electrically interconnecting photovoltaic devices according to an embodiment of the present invention;

FIG. 11 shows an embodiment of electrically interconnecting photovoltaic devices according to another embodiment of the present invention; and

FIG. 12 shows an embodiment of electrically interconnecting photovoltaic devices according to another embodiment of the present invention.

### DETAILED DESCRIPTION

The invention now will be described more fully hereinafter with reference to the accompanying drawings, in which illustrative embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. While such terms as "first," "second," etc., may be used to describe various components, such components must not be limited to the above terms. The above terms are used only to distinguish one component from another. Like numbers refer to like elements throughout.

In the drawings, the thicknesses of layers and regions are exaggerated for clarity. It will be understood that when an element or layer is referred to as being "on" another element or layer, the element or layer can be directly on another element or layer or intervening elements or layers. In contrast, when an element is referred to as being "directly on" another element or layer, there are no intervening elements or layers present.

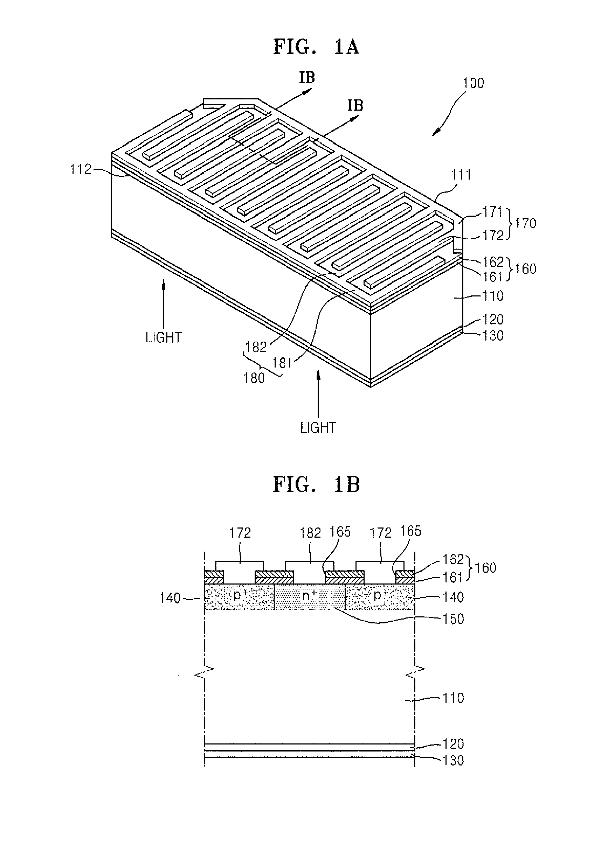

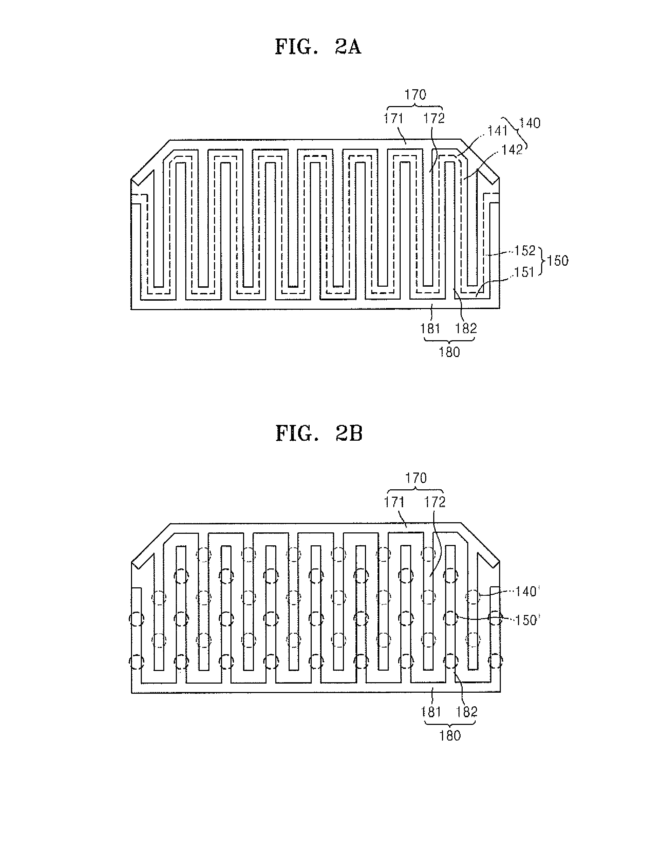

FIG. 1A is a schematic perspective view of a photovoltaic device according to an embodiment of the present invention, and FIG. 1B is a sectional view taken along a line Ib-Ib of FIG. 1A. FIG. 2A is a rear view of a photovoltaic device according to an embodiment of the present invention, showing first and second metal electrodes, an emitter layer, and a base layer, and FIG. 2B is a rear view of a photovoltaic device according to another embodiment of the present invention, showing first and second metal electrodes, an emitter layer, and a base layer.

For convenience of explanation, FIGS. 1A and 1B show a rear surface of the photovoltaic device facing upward, and FIGS. 2A and 2B show regions that are doped with impurities and in which emitter layers and base layers are formed using dotted lines.

Referring to FIGS. 1A and 1B, a photovoltaic device 100 includes a semiconductor substrate 110, a passivation layer 120, an anti-reflection layer 130, an emitter layer 140, a base layer 150, an insulation layer 160, and first and second metal electrodes 170 and 180.

The semiconductor substrate 110 is a light-absorbing layer, where an edge of a first side 111 is trimmed and an edge of a second side 112 is not trimmed. Generally, four edges of a semiconductor substrate are trimmed. However, according to an embodiment of the present invention, the semiconductor substrate 110 corresponds to half of a general semiconductor substrate, where only two of the four edges, that is, only the edges at the two opposite ends of the first side 111, are trimmed. A size of the semiconductor substrate 110 may be half of that of a 5" or 6" wafer or larger.

The semiconductor substrate 110 may include a monocrystalline silicon substrate or a polycrystalline silicon substrate. The semiconductor substrate 110 may be a monocrystalline silicon substrate or a polycrystalline silicon substrate, doped with an n-type impurity. The n-type impurity may include group V atoms, such as phosphor (P) and arsenic (As).

Although the semiconductor substrate 110 doped with an n-type impurity is employed in the present embodiment, the present invention is not limited thereto. For example, the semiconductor substrate 110 may be a monocrystalline silicon substrate or a polycrystalline silicon substrate, doped with a p-type impurity. The p-type impurity may include group III atoms, such as boron (B), aluminum (Al), and gallium (Ga).

Although not shown, the semiconductor substrate 110 may include a textured structure. The textured structure may reduce reflection of incident light , increase the length of propagation of light within the semiconductor substrate 110, and increase the amount of absorbed light by using internal reflection from a rear surface of the semiconductor substrate 110. Therefore, a short circuit current of the photovoltaic device 100 may be increased.

The passivation layer 120 may be formed on a front surface of the semiconductor substrate 110. The passivation layer 120 may contain amorphous silicon (a-Si) doped with an impurity or silicon nitride (SiNₓ). In a case where the passivation layer 120 contains a-Si doped with an impurity, the passivation layer 120 may be doped with an impurity having the same conductivity as the impurity of the semiconductor substrate 110 at a concentration higher than that of the impurity of the semiconductor substrate 110.

The passivation layer 120 may improve efficiency of carrier collection by preventing surface recombination of carriers generated in the semiconductor substrate 110. For example, since the passivation layer 120 prevents carriers from moving toward the front surface of the semiconductor substrate 110, the passivation layer 120 may prevent carriers and holes from being recombined near the front surface of the semiconductor substrate 110 and dissipated.

The anti-reflection layer 130 is formed on the front surface of the semiconductor substrate 110 and may improve efficiency of the photovoltaic device 100 by preventing light absorption loss of the photovoltaic device 100 due to light reflection during incidence of sunlight. The anti-reflection layer 130 may contain a transparent material. For example, the anti-reflection layer 130 may contain silicon oxide (SiOₓ) silicon nitride (SiNₓ), or silicon oxynitride (SiOₓN_{y}). Alternatively, the anti-reflection layer 130 may contain titanium oxide (TiOₓ), zinc oxide (ZnO), or zinc sulfide (ZnO). The anti-reflection layer 130 may be formed by stacking a single layer or a plurality of layers having different refraction indexes.

Although the passivation layer 120 and the anti-reflection layer 130 are formed as individual layers in the present embodiment, the present invention is not limited thereto. For example, a silicon nitride (SiNₓ) layer may be formed to function as both the passivation layer 120 and the anti-reflection layer 130.

The emitter layer 140 is formed on the rear surface of the semiconductor substrate 110 and forms a p-n junction with the semiconductor substrate 110. In a case where the semiconductor substrate 110 is doped with an n-type impurity, the emitter layer 140 contains a p-type impurity. In a case where the semiconductor substrate 110 is doped with a p-type impurity, the emitter layer 140 contains an n-type impurity.

Referring to FIG. 2A, the emitter layer 140 is formed by doping a p-type impurity (or an n-type impurity) to the semiconductor substrate 110, and a diffusion region may be stripe type. Alternatively, referring to FIG. 2B, a diffusion region 140' of a p-type impurity (or an n-type impurity) may be dot type having a circular shape or an elliptical shape. The dot-type diffusion region 140' may also have a polygonal shape.

The emitter layer 140 is formed along the first side 111 of the semiconductor substrate 110, which has two trimmed edges, and is formed in a direction perpendicular to the first side 111. The emitter layer 140 includes a first emitter region 141 formed along the first side 111 and a plurality of second emitter regions 142 formed in a direction substantially perpendicular to the first emitter region 141. The second emitter regions 142 are formed apart from each other.

The base layer 150 is formed on the rear surface of the semiconductor substrate 110 and contains the same type of impurity as the semiconductor substrate 110. The base layer 150 is doped with the impurity at a concentration higher than that of the impurity of the semiconductor substrate 110 to form a back surface field (BSF), so that holes and electrons may be prevented from being recombined near the second metal electrode 180 and dissipated.

Referring to FIG. 2A, the base layer 150 is formed by doping a n-type impurity (or an p-type impurity) to the semiconductor substrate 110, and a diffusion region may be stripe type. Alternatively, referring to FIG. 2B, a diffusion region 150' of a n-type impurity (or an p-type impurity) may be dot type having a circular shape or an elliptical shape. The dot-type diffusion region 150' may also have a polygonal shape.

The dot-type doping region 140' and the dot-type doping region 150' are examples of discrete regions of the emitter layer 140 and the base layer 150 that can be present in some embodiments of the invention.

The base layer 150 is formed along the second side 112 of the semiconductor substrate 110, which has two untrimmed edges, and is formed in a direction perpendicular to the second side 112. The base layer 150 includes a first base region 151 formed along the second side 112 and a plurality of second base regions 152 formed in a direction substantially perpendicular to the first base region 151.

The second base regions 152 are arranged between the second emitter regions 142, which are apart from each other. Therefore, the second emitter regions 142 and the second base regions 152 are formed to be interdigitated on the rear surface of the semiconductor substrate 110.

The insulation layer 160 is formed on the emitter layer 140 and the base layer 150 and below the first and second metal electrodes 170 and 180 to prevent a short-circuit between components having opposite conductivity types. For example, the insulation layer 160 prevents an electric short-circuit between the first metal electrode 170 and the base layer 150 and prevents an electric short-circuit between the second metal electrode 180 and the emitter layer 140.

The insulation layer 160 includes via holes 165 via which the first and second metal electrodes 170 and 180 may directly contact the emitter layer 140 and the base layer 150, respectively. Via the via holes 165, the first metal electrode 170 may be electrically connected to the emitter layer 140 and the second metal electrode 180 may be electrically connected to the base layer 150.

The insulation layer 160 may include a first insulation layer 161 and a second insulation layer 162. For example, the first insulation layer 161 may include silicon oxide (SiOₓ), silicon nitride (SiNₓ), or both SiOₓ and SiNₓ. The second insulation layer 162 is formed for firmer electric insulation after formation of the first insulation layer 161 and may contain polyimide (PI). Alternatively, the second insulation layer 162 may contain ethylenevinylacetate (EVA), polyethylene terephthalate (PET), or polycarbonate (PC).

Although the insulation layer 160 includes the first insulation layer 161 and the second insulation layer 162 in the present embodiment, the present invention is not limited thereto. The second insulation layer 162 may be formed for firmer electric insulation after formation of the first insulation layer 161, thus the insulation layer 160 may include only the first insulation layer 161.

The first metal electrode 170 is arranged on the insulation layer 160 to correspond to the emitter layer 140 and may be electrically connected to the emitter layer 140 through the via holes 165. The first metal electrode 170 may contain silver (Ag), gold (Au), copper (Cu), aluminum (Al), or an alloy thereof. The first metal electrode 170 may include a first bus bar 171 and first finger electrodes 172 that are formed to be perpendicular with respect to the first bus bar 171.

The second metal electrode 180 is arranged on the insulation layer 160 to correspond to the base layer 150 and may be electrically connected to the base layer 150 through the via holes 165. The second metal electrode 180 may contain silver (Ag), gold (Au), copper (Cu), aluminum (Al), or an alloy thereof. The second metal electrode 180 may include a second bus bar 181 and second finger electrodes 182 that are formed to be perpendicular with respect to the second bus bar 181.

The first bus bar 171 is formed at the first side 111 of the semiconductor substrate 110, whereas the second bus bar 181 is formed at the second side 112 of the semiconductor substrate 110 to be substantially parallel to the first bus bar 171. The first finger electrodes 172 extend toward the second bus bar 181 in a direction perpendicular to the first bus bar 171, whereas the second finger electrodes 182 extend toward the first bus bar 171 in a direction perpendicular to the second bus bar 181. The first finger electrodes 182 and the second finger electrodes 182 are alternately arranged, In other words, the first and second finger electrodes 172 and 182 may be formed to be interdigitated with each other and collect carriers.

In a case of fabricating a general back contact photovoltaic device, even though a light-receiving area increases, power loss proportional to the square of a current is induced when the current is increased according to the increase of the light-receiving area, and thus gain with respect to the increase of area may not be sufficiently large. However, according to embodiments of the present invention, a photovoltaic device is formed by dicing a wafer in half, and thus a voltage may be approximately doubled and a current may be reduced. Therefore, loss of a current may be reduced.

Furthermore, since a photovoltaic device according to an embodiment the present invention is fabricated by dicing a portion of a base region, power loss during fabrication of the photovoltaic device may be prevented.

In some embodiments of the present invention, semiconductor substrate 110 is doped with an impurity having a first polarity, the base layer 150 is doped with an impurity having the said first polarity, and the emitter layer 140 is doped with a second polarity. The emitter layer 140 comprises of a plurality of emitter portions, wherein the second emitter portions branch from the first emitter portion. The base layer 150 comprises a plurality of base portions, wherein the second base portions branch from the first base portion. At least some of the base portions and at least some of the emitter portions are interspersed with each other.

Hence, in such embodiments, the first electrode 170 is situated over at least part of the emitter layer 140 and the second electrode 180 is situated over at least part of the base layer 150. The first electrode 170 comprises a first electrode bus bar 171 and a plurality of first electrode branches 172 extending from the first electrode bus bar 171, and the second electrode 180 comprises a second electrode bus bar 181 and a plurality of second electrode branches 182 extending from the second electrode bus bar. Second electrode branches are interspersed with the first electrode branches. The second electrode bus bar 180 is elongate and extends along a diced edge 112 of the substrate 110.

Hereinafter, a method of fabricating a photovoltaic device will be described.

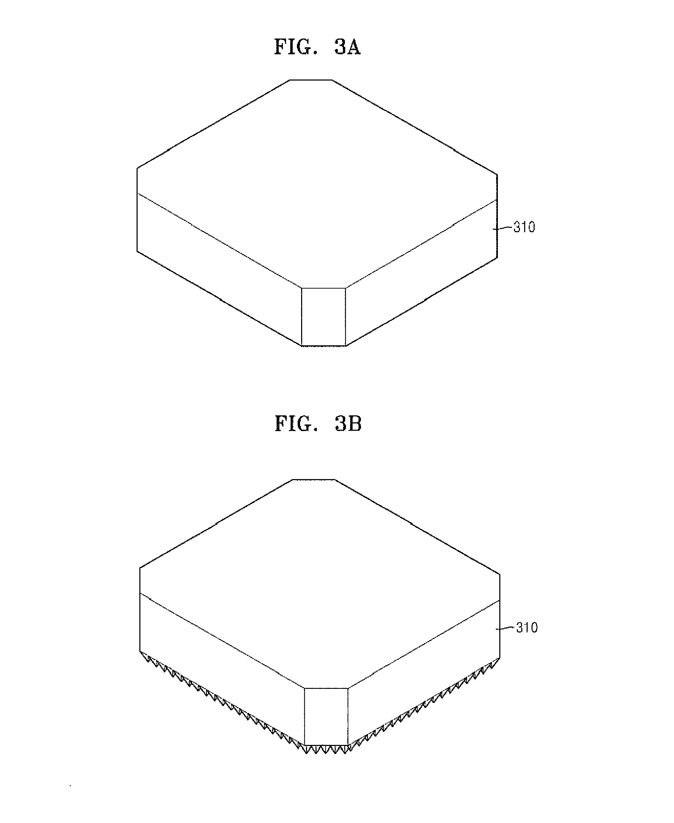

FIGS. 3A through 8B schematically show states in a method of fabricating a photovoltaic device according to an embodiment of the present invention. For convenience of explanation, FIGS. 3A through 8B show a rear surface of the photovoltaic device facing upward.

Referring to FIG. 3A, a semiconductor substrate 310 is provided. The four edges of the semiconductor substrate 310 are trimmed, and a size of the semiconductor substrate 310 may be 5-inch, 6-inch, or larger.

The semiconductor substrate 310 may include a monocrystalline silicon substrate or a polycrystalline silicon substrate. The semiconductor substrate 310 may be a monocrystalline silicon substrate or a polycrystalline silicon substrate, doped with an n-type impurity or a p-type impurity. In the present embodiment, for convenience of explanation, a case in which the semiconductor substrate 310 contains an n-type impurity will be described.

A cleaning operation using an acid solution or an alkali solution may be performed to remove physical impurities and/or chemical impurities attached to surfaces of the semiconductor substrate 310.

Referring to FIG. 3B, a semiconductor substrate 310' according to another embodiment of the present invention may have a rough surface formed in a texturing operation. A texture structure may be formed via anisotropic wet-etching or plasma dry-etching. A passivation layer and an anti-reflection layer described below may be formed on the rough surface formed in the texturing operation.

Hereinafter, for convenience of explanation, a process of fabricating a photovoltaic device using the semiconductor substrate 310 shown in FIG. 3A will be described.

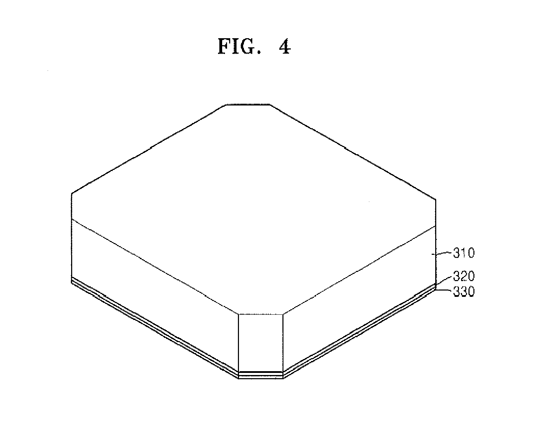

Referring to FIG. 4, a passivation layer 320 and an anti-reflection layer 330 are formed on a front surface of the semiconductor substrate 310 in the order stated. Before the passivation layer 320 is formed, the semiconductor substrate 310 may be cleaned.

The passivation layer 320 may contain a-Si doped with an impurity. For example, the passivation layer 320 may be formed on the front surface of the semiconductor substrate 310 as a high-concentration n+ layer, and the passivation layer 320 may form a front surface field (FSF) for reducing loss due to recombination of holes and electrons.

According to another embodiment of the present invention, the passivation layer 320 may contain silicon nitride (SiNₓ). The passivation layer 320 may be formed by using a plasma enhanced chemical vapor deposition (PECVD) method.

Since the passivation layer 320 is formed on a light-receiving surface of the semiconductor substrate 310, a band gap may be adjusted to reduce light absorption. For example, an additive may be added to increase a band gap to reduce light absorption, in order to pass more incident light into an interior of the semiconductor substrate 310.

The anti-reflection layer 330 may be formed of silicon oxide (SiOₓ), silicon nitride (SiNₓ), or silicon oxynitride (SiOₓN_{y}), by using a method such as CVD, sputtering, and spin coating. For example, the anti-reflection layer 330 may be formed as a single silicon oxide (SiOₓ) layer, a single silicon nitride (SiNₓ) layer, or a single silicon oxynitride (SiOₓN_{y}) layer, or as a composite layer containing silicon oxide (SiOₓ), silicon nitride (SiNₓ), and silicon oxynitride (SiOₓN_{y}).

Although the passivation layer 320 and the anti-reflection layer 330 are formed as individual layers in the present embodiment, the present invention is not limited thereto. For example, the passivation layer 320 and the anti-reflection layer 330 may be formed as a single layer. In other words, a silicon nitride (SiNₓ) layer may be formed for both passivation and anti-reflection.

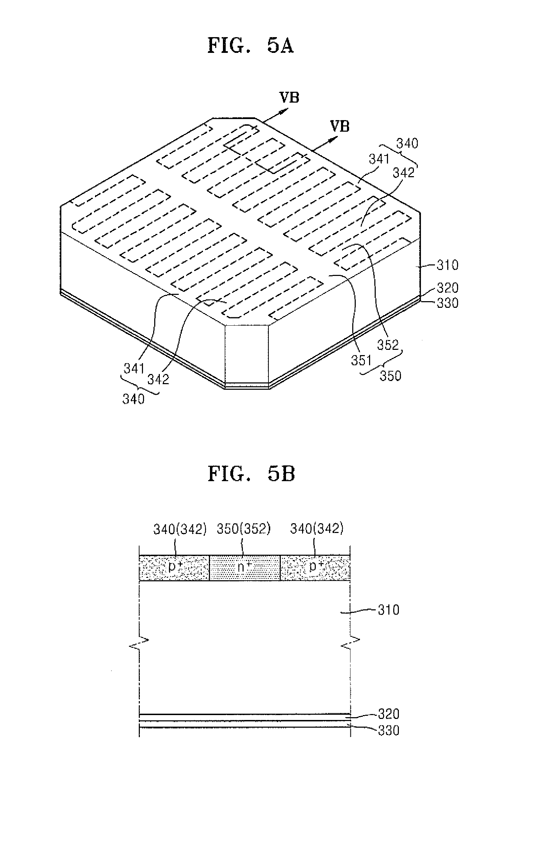

Referring to FIGS. 5A and 5B, a base layer 350 and emitter layers 340 are formed on the rear surface of the semiconductor substrate 310. The base layer 350 and the emitter layers 340 may be formed by doping an impurity into the semiconductor substrate 310 in stripes.

According to an embodiment of the present invention, the base layer 350 and the emitter layers 340 may be formed by respectively doping impurities of opposite conductivity types to different regions of the rear surface of the semiconductor substrate 310. First, a first base region 351 may be formed by doping an n-type impurity into the semiconductor substrate 310 across a center region of the rear surface of the semiconductor substrate 310, and second base regions 352 may be formed by doping the n-type impurity into the semiconductor substrate 310 in a direction perpendicular to the first base region 351. Here, the second base regions 352 doped with the n-type impurity are formed to be a predetermined interval apart from each other.

Next, the emitter layers 340 may be formed by doping a p-type impurity into remaining regions, that is, regions other than the regions doped with the n-type impurity. Therefore, the emitter layers 340 are formed at two different sides around the base layer 350, and each of the emitter layers 340 include a first emitter region 341 and second emitter regions 342 substantially perpendicular to the first emitter region 341, where the second emitter regions 342 are formed to be interdigitated with the second base regions 352.

According to another embodiment of the present invention, the base layer 350 is formed to cover the entire rear surface of the semiconductor substrate 310, and then the emitter layer 340 may be formed by selectively doping an impurity into portions of the base layer 350. For example, after the entire rear surface of the semiconductor substrate 310 is doped with an n-type impurity, portions of the rear surface of the semiconductor substrate 310 may be doped with a high-concentration p-type impurity to form the emitter layer 340. Here, the portions doped with the high-concentration p-type impurity are as shown in FIG. 5A.

Although the base layer 350 and the emitter layers 340 are stripe type doped regions, impurities may also be doped in dot shapes. A base doped region and an emitter doped region in a case where impurities are doped in dot shapes are as described above with reference to FIG. 2B. The formation of dot-type diffusion regions 140' and 150' as described above in FIG. 2B is an example of plurality of discrete regions being formed in at least one of the base layer and the emitter layer, which can be present in some embodiments of the invention.

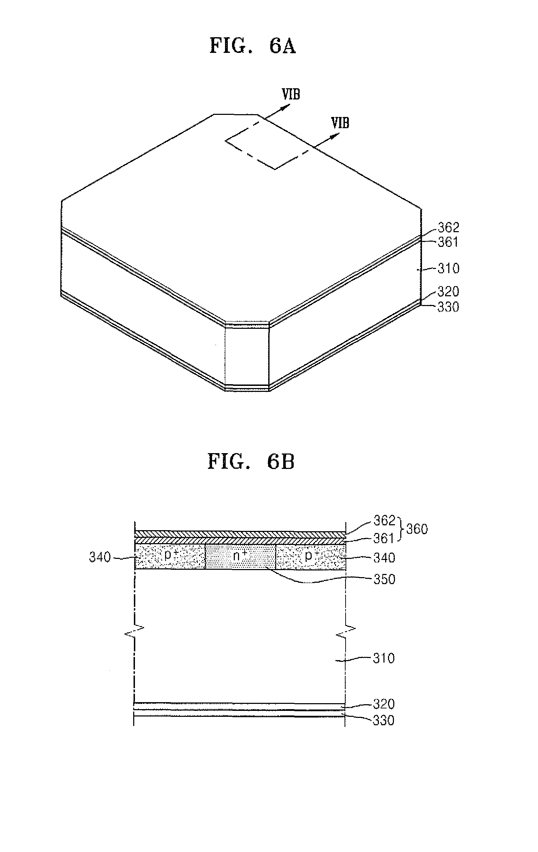

Referring to FIGS. 6A and 6B, an insulation layer 360 is formed on the base layer 350 and the emitter layers 340. The insulation layer 360 may be formed to include two layers. For example, after a first insulation layer 361 containing silicon oxide (SiOₓ) and silicon nitride (SiNₓ) is formed by using a CVD method, a second insulation layer 362 may be formed to improve electric insulation.

The second insulation layer 362 may contain polyimide (PI). Alternatively, the second insulation layer 162 may contain ethylenevinylacetate (EVA), polyethylene terephthalate (PET), or polycarbonate (PC).

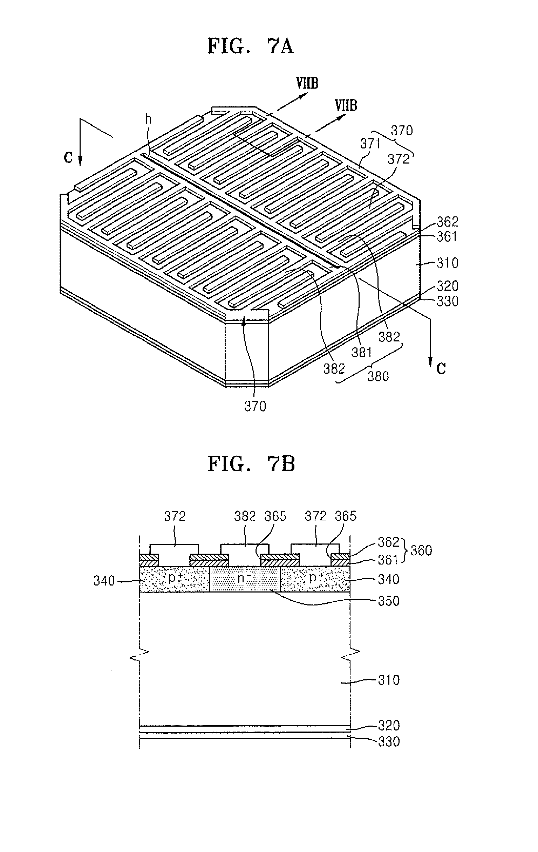

Next, via holes 365 are formed in the insulation layer 360 to partially expose the base layer 350 and the emitter layer 340 (refer to FIG. 7B). Although not shown, the via holes 365 may be formed by forming an etching mask (not shown) on the insulation layer 360 and etching a portion of the insulation layer 360 exposed by the etching mask.

The base layer 350 may be partially exposed via some of the plurality of via holes 365, and the emitter layers 340 may be partially exposed via the remaining via holes 365. Some of the via holes 365 are for electric connection between the emitter layers 340 and first metal electrodes 370, whereas the remaining vial holes 365 are for electric connection between the base layer 350 and second metal electrodes 380.

Referring to FIGS. 7A through 7C, the first and second metal electrodes 370 and 380 are formed.

The first metal electrodes 370 are formed at two opposite ends of the rear surface of the semiconductor substrate 310. At least a portion of the first metal electrodes 370 contacts the doped emitter layers 340. The first metal electrodes 370 each includes a first bus bar 371 and first finger electrodes 372 that are formed in a direction perpendicular to the first bus bar 371.

The second metal electrode 380 is formed at the center of the rear surface of the semiconductor substrate 310. For example, the second metal electrode 380 includes a second bus bar 381 arranged across the center of the semiconductor substrate 310 and second finger electrodes 382 that are formed at two opposite sides around the second bus bar 381 and extend toward the first metal electrodes 370. For example, the second finger electrodes 382 extend in directions substantially perpendicular to the second bus bar 381. The second finger electrodes 382 may be formed to be interdigitated with the first finger electrodes 372 and collect carriers.

The first and second metal electrodes 370 and 380 may be formed by screenprinting a pattern formed of a conductive paste containing silver (Ag), gold (Au), copper (Cu), aluminum (AI), or nickel (Ni), and thermally baking the pattern.

According to another embodiment of the present invention, the first and second metal electrodes 370 and 380 may be formed by plating. Afrer forming seed layers contacting the emitter layer 340 and the base layer 350 via the via holes 365, a metal may be plated on the seed layers.

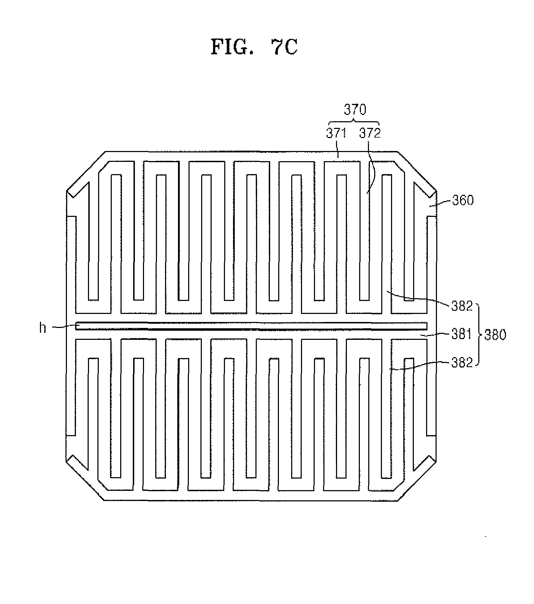

When the second metal electrode 380 is formed, it is necessary to form a hole h at a center of the second bus bar 381 in a lengthwise direction (refer to FIGS. 7A and 7C). The substrate can be diced along such a line 11 extending within the second electrode bus bar formation 381. For example, during formation of the second metal electrode 380, a paste is applied or a metal is plated regions other than a region corresponding to the hole h so that no metal is formed at the center of the second bus bar 381. A line C-C across the hole h formed at the center of the second bus bar 381 becomes a dicing line.

Hence, in some embodiments, the base layer 350 is formed on a first surface of the substrate 310 by doping an impurity having a first polarity into a plurality of base regions 351, 352. The emitter layer 240 is formed on the first surface of the substrate 310 by doping an impurity having a second polarity into a plurality of emitter regions 341, 342 that are interspersed with the base regions 351, 352.

Then, two first electrode structures 370 are formed over at least part of the emitter layer 340, each said first electrode structure 370 having a respective first electrode bus bar 371 and a plurality of the first electrode branches 372. the second electrode structure 380 is formed over at least part of the base layer 350, the said second electrode structure 380 having a second electrode bus bar formation 381 and a plurality of second electrode branches 382, the second electrode branches 382 being interspersed with the first electrode branches372. The second electrode bus bar formation 381 extends along a substantially central region of the substrate 310. The substrate is diced along a line 11 extending within the second electrode bus bar formation 381.

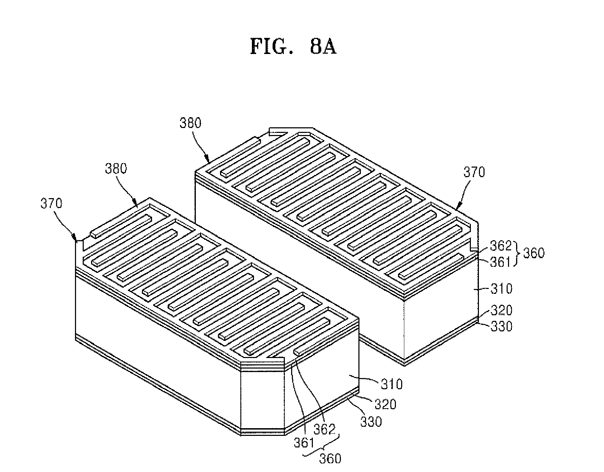

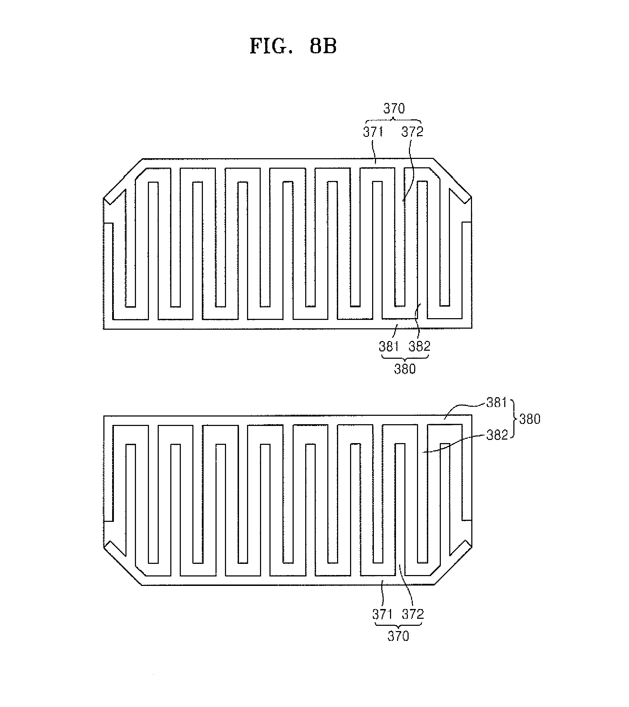

Referring to FIGS. 8A and 8B, two photovoltaic devices may be formed by dicing the semiconductor substrate 310 along the dicing line. The semiconductor substrate 310 may be diced by using laser scribing. Alternatively, the semiconductor substrate 310 may be diced by using wire sawing. Since the dicing is performed with respect to a base region of a photovoltaic device, possible power loss in fabrication of a photovoltaic device may be minimized. A detailed description thereof will be given below.

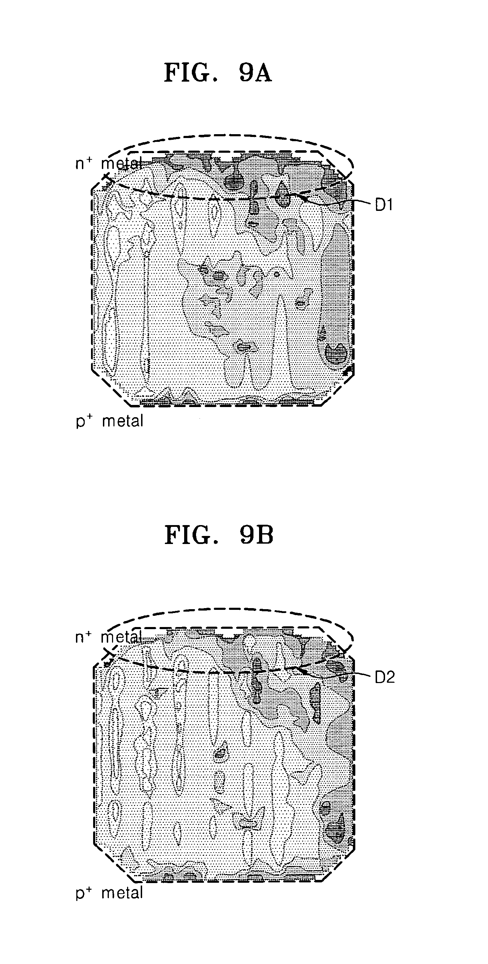

FIGS. 9A and 9B show results of measuring quantum efficiencies (QEs) of a back contact photovoltaic device using a laser beam induced current (LBIC) method.

Referring to FIGS. 9A and 9B, a base regions are indicated as dark spaces D1 and D2. Dark base regions indicate a significantly low current in the corresponding regions. In other words, the base regions make little contribution to efficiency of a photovoltaic device.

Since a base region is used as a dicing region according to embodiments of the present invention, loss due to damaged regions formed during a dicing operation may be minimized.

As described above, as compared to finger electrodes of a photovoltaic device in the related art, first and second metal electrodes 170 and 180 of a photovoltaic device according to an embodiment of the present invention may have finger electrodes 172 and 182 with relatively small lengths, and thus power loss may be reduced. Furthermore, since thicknesses of the metal electrodes 170 and 180 may be reduced, cost for forming the first and second metal electrodes 170 and 180 may be reduced, and bowing of the semiconductor substrate 110 may be prevented.

And, according to fabricating method of the present invention, a plurality of photovoltaic devices may be produced and the number of processes may be minimized. For example, two photovoltaic devices may be fabricated by the entire process (1 cycle) explained according to FIGS. 3A through 8B, Therefore, high efficiency photovoltaic devices may be produced with minimized cost and time.

However, according to embodiments of the present invention, a photovoltaic device is formed by dicing a wafer in half, and thus a voltage may be approximately doubled and a current may be reduced. Therefore, loss of a current may be reduced

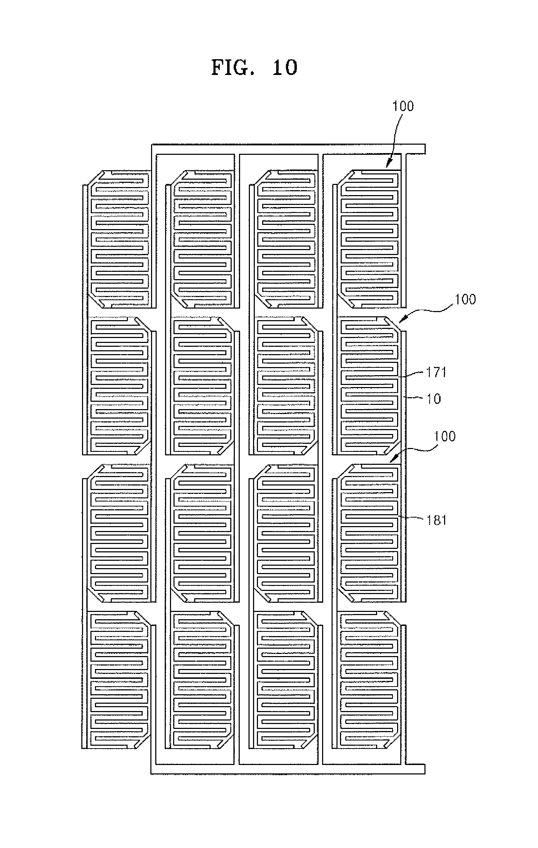

FIGS. 10 through 12 show embodiments of electrically connecting photovoltaic devices according to other embodiments of the present invention.

Referring to FIGS. 10 through 12, modules may be manufactured by electrically interconnecting a plurality of photovoltaic devices by using combinations of serial connections and parallel connections by using ribbons.

Referring to FIG. 10, a single module may be formed by using serial connections by interconnecting the first bus bar 171 arranged at a first end of one of the photovoltaic devices 100 and the second bus bar 181 arranged at a second end of another one of the photovoltaic devices 100 by using a ribbon 10 and interconnecting columns of the photovoltaic devices 100 in parallel.

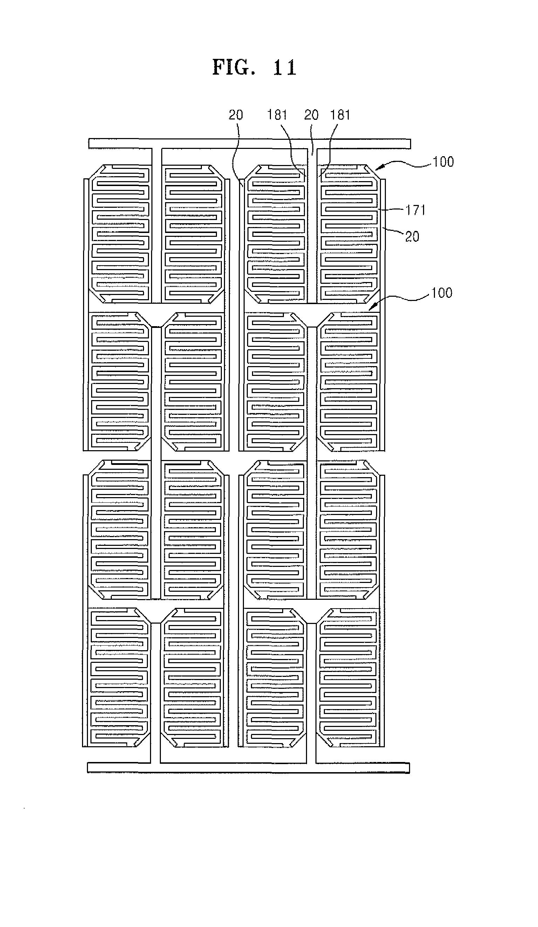

Referring to FIG. 11, a single module may be formed by using a parallel connection by interconnecting the second bus bar 181 arranged at a first end of one of the photovoltaic devices 100 and the second bus bar 181 arranged at a first end of another one of the photovoltaic devices 100 by using a ribbon 20 and interconnecting the photovoltaic devices 100 in series.

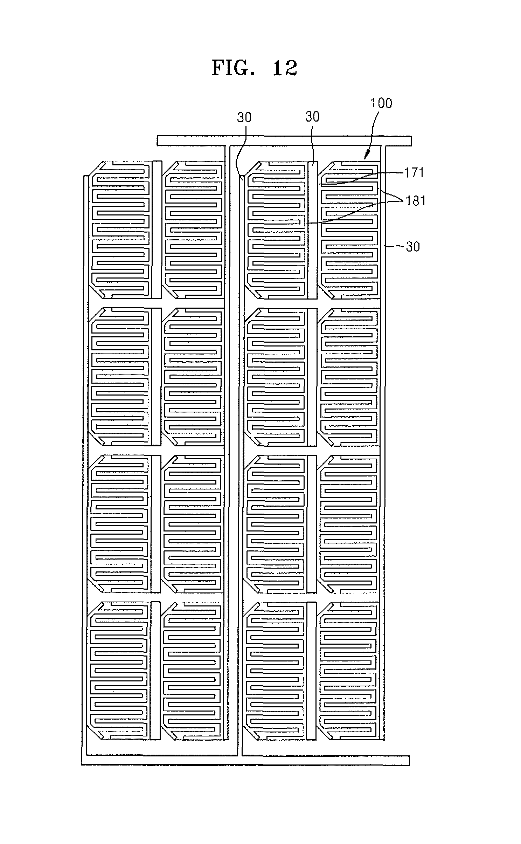

Similarly, referring to FIG. 12, a single module may be formed by interconnecting the second bus bar 181 of one of the photovoltaic devices 100 and the first bus bar 171 of another one of the photovoltaic device 100 in series and interconnecting the photovoltaic devices 100 in parallel.

Other than the embodiments described above, a plurality of photovoltaic devices may be connected to each others in series and/or in parallel via any of various combinations and arrangements.

While this invention has been particularly shown and described with reference to preferred embodiments thereof, it will be understood by those skilled in the art that various changes in form and details may be made therein without departing from the scope of the invention as defined by the appended claims. The preferred embodiments should be considered in descriptive sense only and not for purposes of limitation. Therefore, the scope of the invention is defined not by the detailed description of the invention but by the appended claims, and all differences within the scope will be construed as being included in the present invention.

## Claims

1. A photovoltaic device (100) comprising:
a semiconductor substrate (110) doped with an impurity having a first polarity;
a base layer (150) doped with an impurity having the said first polarity and an emitter layer (140) doped with an impurity having a second polarity, the said base layer (150) and emitter layer (140) being situated over a surface of the substrate (110);
a first electrode (170); and
a second electrode (180);
wherein the base layer (150) comprises a plurality of base portions;
the emitter layer (140) comprises a plurality of emitter portions;
at least some of the base portions and at least some of the emitter portions are interspersed with each other;
the first electrode (170) comprises a first electrode bus bar (171) and a plurality of first electrode branches (172) extending from the first electrode bus bar (171);
the second electrode (180) comprises a second electrode bus bar (181) and a plurality of second electrode branches (182) extending from the second electrode bus bar (181) and interspersed with the first electrode branches (172);
the first electrode (170) is situated over at least part of the emitter layer (140); and
the second electrode (180) is situated over at least part of the base layer (150);
**characterised in that** the second electrode bus bar (180) is elongate and extends along a diced edge (112) of the substrate (110).

2. A photovoltaic device (100) according to claim 1, wherein the base portions comprise a first base portion (151) and a plurality of second base portions (152) that branch from the first base portion (151);
the emitter portions comprise a first emitter portion (141) and a plurality of second emitter portions (142) that branch from the first emitter portion (141) and are interspersed with the second base portions (152);
the first electrode bus bar (171) is situated over the first emitter portion (141); the first electrode branches (172) are situated over the second emitter portions (142);
the second electrode bus bar (181) is situated over the first base portion (151);
and
the second electrode branches (182) are situated over the second base portions (152).

3. A photovoltaic device (100) according to claim 2, wherein the said second base portions (152) are elongate and extend substantially perpendicularly to the first base portion (151), and the said second emitter portions (142) are elongate and extend substantially perpendicularly to the first emitter portion (141).

4. A photovoltaic device (100) according to claim 1, wherein at least one of the base layer (150) and the emitter layer (140) comprises a plurality of discrete doping regions (140'; 150').

5. A photovoltaic device (100) according to claim 4, wherein the discrete regions (140'; 150') are substantially dot-shaped, elliptical, circular or polygonal.

6. A photovoltaic device (100) according to any preceding claim, wherein the first electrode branches (172) are elongate and extend substantially perpendicular to the first electrode bus bar (171), and the second electrode branches (182) are elongate and extend substantially perpendicularly to the second electrode bus bar (181).

7. A photovoltaic device (100) according to any preceding claim wherein an edge (111) of the substrate that is opposite to the said diced edge (112) is trimmed.

8. A photovoltaic device (100) according to any preceding claim, comprising an insulation layer (160) situated over the base and emitter layers (140'; 150'), the said insulation layer (160) comprising via holes (165) through with the first and second electrodes (170, 180) make electrical contact with the emitter layer (140) and the base layer (150) respectively.

9. A photovoltaic device according to claim 8, wherein the insulation layer (160) comprises first and second insulating layers (161, 162) arranged one upon another.

10. A method of manufacturing a pair of photovoltaic devices, comprising:
providing a semiconductor substrate (310);
forming a base layer (350) on a first surface of the substrate (310) by doping an impurity having a first polarity into a plurality of base regions (351, 352);
forming an emitter layer (340) on the first surface of the substrate (310) by doping an impurity having a second polarity into a plurality of emitter regions (341, 342) that are interspersed with the base regions (351, 352);
forming two first electrode structures (370) over at least part of the said emitter layer (340), each said first electrode structure (370) having a respective first electrode bus bar (371) and a plurality of first electrode branches (372);
forming a second electrode structure (380) over at least part of the said base layer (350), the said second electrode structure (380) having a second electrode bus bar formation (381) and a plurality of second electrode branches (382), the said second electrode branches (382) being interspersed with the said first electrode branches (372); and
dicing the substrate along a line (11) extending within the second electrode bus bar formation (381).

11. A method according to according to claim 10, wherein the emitter regions are formed with a pair of first emitter portions (341) and a plurality of second emitter portions (342) that branch from the first emitter portions (341);
the base regions are formed with a first base portion (351) and a plurality of second base portions (352) that branch from the first base portion (351) and are interspersed with the second emitter portions (342);
the first electrode bus bars (371) are each provided over a respective one of the first emitter portions (341);
the first electrode branches (372) are provided over the second emitter portions (342),
the second electrode bus bar formation (382) is provided over the first base portion (351); and
the second electrode branches (382) are provided over the second base portions (352).

12. A method according to claim 11, wherein the said second base portions (352) are formed to be elongate and extend substantially perpendicularly to the first base portion (351), and the said second emitter portions (342) are formed to be elongate and extend substantially perpendicularly to the first emitter portions (341).

13. A method according to claim 10, comprising forming a plurality of discrete regions in at least one of the base layer (350) and the emitter layer (340).

14. A method according to one of claims 10 to 13, wherein the first electrode branches (372) are formed to be elongate and extend substantially perpendicular to the first electrode bus bars (371) , and the second electrode branches (382) are formed to be elongate and extend substantially perpendicular to the second electrode bus bar formation (381).

15. A method according to one of claims 10 to 14, wherein the second electrode bus bar formation (381) extends along a substantially central region of the substrate (310).
